(19) **Europäisches Patentamt / European Patent Office / Office européen des brevets**

(11) **EP 3 015 853 A1**

(12) **EUROPEAN PATENT APPLICATION**
published in accordance with Art. 153(4) EPC

(43) Date of publication:
**04.05.2016 Bulletin 2016/18**

(21) Application number: **14817826.2**

(22) Date of filing: **03.06.2014**

(51) Int Cl.:
*G01N 23/207* [(2006.01)]     *C01B 33/02* [(2006.01)]
*C30B 29/06* [(2006.01)]

(86) International application number:
**PCT/JP2014/002925**

(87) International publication number:
**WO 2014/208007 (31.12.2014 Gazette 2014/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.06.2013 JP 2013134123**

(71) Applicant: **Shin-Etsu Chemical Co., Ltd.**
**Tokyo 100-0004 (JP)**

(72) Inventors:
• **MIYAO, Shuichi**
  **Joetsu-shi, Niigata 942-8601 (JP)**
• **NETSU, Shigeyoshi**
  **Joetsu-shi, Niigata 942-8601 (JP)**

(74) Representative: **Smaggasgale, Gillian Helen**
**WP Thompson**
**138 Fetter Lane**
**London EC4A 1BT (GB)**

(54) **METHOD FOR EVALUATING CRYSTAL GRAIN SIZE DISTRIBUTION OF POLYCRYSTALLINE SILICON**

(57) The method comprises following steps; a collected disk sample (20) is disposed at a position where Bragg reflection from a Miller index plane <hkl> is detected; the disk sample (20) is rotated in-plane about the center thereof by a rotation angle φ so that an X-ray irradiation region defined by a slit φ-scans the principal plane of the disk sample (20); a chart showing the dependence of intensity of the Bragg reflection on the rotation angle(φ) of the disk sample (20) is determined; the amount of change per a unit rotation angle of diffraction intensity of a baseline of the φ scan chart is determined as a first derivative value; skewness in the normal distribution of the absolute value of the amount of change is calculated; and the skewness is used as an evaluation index of the crystal grain size distribution to select polycrystalline silicon.

FIG.13B

EP 3 015 853 A1

**Description**

Technical Field

The present invention relates to a method for evaluating crystal grain size distribution of polycrystalline silicon by an X-ray diffraction method, and to a method of selecting a polycrystalline silicon rod or a polycrystalline silicon block suitable as a raw material for stably producing single crystal silicon utilizing the evaluation method.

Background Art

Single crystal silicon indispensable for producing semiconductor devices and the like is crystal-grown by the CZ method and the FZ method, and a polycrystalline silicon rod and a polycrystalline silicon block are used as a raw material in these methods. In many cases, such a polycrystalline silicon material is produced by the Siemens method (see Patent Literature 1 or the like). The Siemens method is a method in which a silane raw material gas such as trichlorosilane and monosilane is brought into contact with a heated silicon core wire to thereby grow (deposit) polycrystalline silicon on the surface of the silicon core wire by the CVD (Chemical Vapor Deposition) method.

For example, when single crystal silicon is crystal-grown by the CZ method, a polycrystalline silicon block is charged in a quartz crucible and melted by heating to obtain silicon melt; a seed crystal is immersed in the silicon melt and a dislocation line is disappeared (dislocation-free growth); and then the crystal is pulled up while gradually increasing the diameter until a predetermined diameter is obtained. If unmelted polycrystalline silicon remains in the silicon melt at this time, the unmelted polycrystalline piece is drifted in the vicinity of an interface of solid and liquid phases by the convection, inducing the generation of dislocation and causing a crystal line to be disappeared.

Further, Patent Literature 2 indicates the following problem: in a step of producing a polycrystalline silicon rod by the Siemens method, needle crystals may be deposited in the rod, and if single crystal silicon is grown by the FZ method using such a polycrystalline silicon rod, the rod does not melt uniformly since the melting of each crystallite depends on the size thereof, and the unmelted crystallites pass through a melt zone to a single crystal rod as solid particles and are incorporated into the solidified surface of the single crystal as unmelted particles, causing the formation of defects.

To this problem, Patent Literature 2 proposes a technique in which the surface of a sample cut out perpendicular to the major axis direction of a polycrystalline silicon rod is ground or polished; the contrast of the surface is increased to such an extent that the microcrystals of the structure can be visually recognized after etching even under an optical microscope; the size of the needle crystals and the area ratio thereof are measured; and the suitability as a raw material for growing FZ single crystal silicon is determined based on the test results.

Citation List

Patent Literature

Patent Literature 1: Japanese Patent Publication No. 37-18861
Patent Literature 2: Japanese Patent Laid-Open No. 2008-285403

Summary of Invention

Technical Problem

However, the suitability determination by visual recognition under an optical microscope such as a technique disclosed in Patent Literature 2 easily produces a difference in the results depending on the degree of etching of the surface of an observation sample, an observation skill of a person in charge of evaluation, and the like and in addition is poor in quantitativity and reproducibility. Therefore, from the point of view of increasing the production yield of single crystal silicon, it is necessary to set the criterion of suitability determination of polycrystalline silicon serving as a raw material at a high level, and as a result, the defective rate of a polycrystalline silicon rod will be increased.

Further, according to the investigation of the present inventors, it is observed in the technique disclosed in Patent Literature 2 that even when a polycrystalline silicon rod determined to be non-defective is used, dislocation may be produced and a crystal line may disappear in the step of growing a single crystal silicon rod by the FZ method, and on the other hand, even when a polycrystalline silicon rod determined to be defective is used, an FZ single crystal may be satisfactorily obtained.

Further, the method disclosed in Patent Literature 2 is a method for evaluating the existence or nonexistence and the distribution of needle crystals and is not a method capable of evaluating other crystalline states (crystallinity itself, crystal grain size distribution, and the like).

As described above, in view of the fact that, even when a polycrystalline silicon rod determined to be non-defective by the technique disclosed in Patent Literature 2 is used, dislocation may be produced and a crystal line may disappear in the step of growing a single crystal silicon rod by the FZ method, it is required to perform the evaluation of the overall crystalline state including not only the macroscopic crystalline state such as needle crystals but also the microscopic crystalline state, in order to select polycrystalline silicon suitable as a raw material for producing single crystal silicon.

Thus, in order to stably produce single crystal silicon with a high yield, a high technique of selecting polycrystalline silicon suitable as a raw material for producing single crystal silicon with high quantitativity and reproducibility is required.

The present invention has been made in view of the above problems and has an object to provide a technique of selecting polycrystalline silicon suitable as a raw material for producing single crystal silicon with high quantitativity and reproducibility and contributing to the stable production of single crystal silicon.

Solution to Problem

In order to solve the above problems, the method for evaluating crystal grain size distribution of polycrystalline silicon according to the present invention comprises a method for evaluating crystal grain size distribution of polycrystalline silicon by an X-ray diffraction method, the method comprising: preparing a plate sample of the polycrystalline silicon; disposing the plate sample at a position where Bragg reflection from a Miller index plane <hkl> is detected; rotating the plate sample in-plane about the center thereof by a rotation angle $\phi$ so that an X-ray irradiation region defined by a slit $\phi$-scans a principal plane of the plate sample; determining a $\phi$ scan chart showing the dependence of the intensity of the Bragg reflection from the Miller index plane <hkl> on the rotation angle ($\phi$) of the plate sample; determining the amount of change per a unit rotation angle of the diffraction intensity of the baseline of the $\phi$ scan chart as a first derivative value; calculating skewness in the normal distribution of the absolute value of the amount of change by the following equation; and using the skewness (b value) as an evaluation index of the crystal grain size distribution.

[Expression 1]

$$b = \frac{\left| n \sum_{i=1}^{n} \left( \frac{x_i - \overline{x}}{s} \right)^3 \right|}{\left| (n-1)(n-2) \right|}$$

In the equation, n represents the number of data; s represents standard deviation; $x_i$ represents the i-th data; and x bar represents an average value.

Preferably, the Miller index plane <hkl> is any of a plane <111> and a plane <220>.

Further, the method for selecting a polycrystalline silicon rod according to the present invention comprises a method for selecting a polycrystalline silicon rod to be used as a raw material for producing single crystal silicon using an X-ray diffraction method, the polycrystalline silicon rod being grown by deposition by a chemical vapor deposition method, the method for selecting the polycrystalline silicon rod comprising: collecting a plate sample having a section perpendicular to a diameter direction of the polycrystalline silicon rod as a principal plane; disposing the plate sample at a position where Bragg reflection from a Miller index plane <hkl> is detected; rotating the plate sample in-plane about the center thereof by a rotation angle $\phi$ so that an X-ray irradiation region defined by a slit $\phi$-scans the principal plane of the plate sample; determining a $\phi$ scan chart showing the dependence of the intensity of the Bragg reflection from the Miller index plane <hkl> on the rotation angle ($\phi$) of the plate sample; determining the amount of change per a unit rotation angle of the diffraction intensity of the baseline of the $\phi$ scan chart as a first derivative value; calculating skewness in the normal distribution of the absolute value of the amount of change by the following equation; and using the skewness (b value) as an evaluation index of the crystal grain size distribution to determine the suitability as a raw material for producing single crystal silicon.

## [Expression 2]

$$b = \frac{\left| n \sum_{i=1}^{n} \left( \frac{x_i - \overline{x}}{s} \right)^3 \right|}{\left| (n-1)(n-2) \right|}$$

In the equation, n represents the number of data; s represents standard deviation; $x_i$ represents the i-th data; and x bar represents an average value.

Preferably, the Miller index plane <hkl> is any of a plane <111> and a plane <220>.

In a preferred embodiment, when the Miller index <hkl> is a plane <111>, and the b value is 1.12 or less, such a polycrystalline silicon rod is selected as a raw material for producing single crystal silicon.

In another preferred embodiment, when the Miller index <hkl> is a plane <220>, and the b value is 1.12 or less, such a polycrystalline silicon rod is selected as a raw material for producing single crystal silicon.

For example, the polycrystalline silicon rod has been grown by the Siemens method.

In the method for producing single crystal silicon according to the present invention, a polycrystalline silicon rod selected by the method as described above or a polycrystalline silicon block obtained by crushing the polycrystalline silicon rod is used as a raw material.

Advantageous Effects of Invention

The polycrystalline silicon rod selected by the method of the present invention has relatively high uniformity of crystal grain size in the meaning that a local unmelted state hardly occurs. Therefore, a local unmelted state is suppressed and the stable production of single crystal silicon is achieved, when a single crystal is grown by the FZ method using such a polycrystalline silicon rod, or when a single crystal is grown by the CZ method using a polycrystalline silicon block obtained by crushing the polycrystalline silicon rod.

Brief Description of Drawings

[Figure 1A] Figure 1A is a view showing an example in which the amount of change per a unit rotation angle of the diffraction intensity of the baseline of the $\phi$ scan chart is determined as a first derivative value, and a histogram of the derivative values is prepared.

[Figure 1B] Figure 1B is a view showing a histogram of the absolute value of the data shown in Figure 1A.

[Figure 2A] Figure 2A is an example of the $\phi$ scan chart ($\phi$ = 0 to 360°) obtained by scanning the Miller index plane <111>.

[Figure 2B] Figure 2B is a view in which the range of $\phi$ = 100 to 102° of the $\phi$ scan chart shown in Figure 2A has been expanded.

[Figure 3A] Figure 3A is a view showing the correlation between the diffraction intensity change ($\Delta$CPS) determined from the $\phi$ scan chart obtained by X-ray diffraction from the Miller index plane <111> and the values of the crystal grain size calculated from the results of EBSD measurement.

[Figure 3B] Figure 3B is a view showing the correlation between the diffraction intensity change ($\Delta$CPS) determined from the $\phi$ scan chart obtained by X-ray diffraction from the Miller index plane <220> and the values of the crystal grain size calculated from the results of EBSD measurement.

[Figure 4A] Figure 4A is a view for describing an example of collecting a plate sample for measuring X-ray diffraction from a polycrystalline silicon rod grown by deposition by a chemical vapor deposition method.

[Figure 4B] Figure 4B is a view for describing an example of collecting a plate sample for measuring X-ray diffraction from a polycrystalline silicon rod grown by deposition by a chemical vapor deposition method.

[Figure 5] Figure 5 is a view for describing the outline of an example of a system of measurement for determining an X-ray diffraction profile from a plate sample by the $\theta$-$2\theta$ method.

[Figure 6] Figure 6 is an example of a $\theta$-$2\theta$ X-ray diffraction chart.

[Figure 7] Figure 7 is a view for describing the outline of an example of a system of measurement for determining an X-ray diffraction profile from a plate sample by the $\phi$ scan method.

[Figure 8] Figure 8 is an example of the charts obtained by performing the $\phi$ scan measurement shown in Figure 7 on the Miller index planes <111 >, <220>, <311>, and <400>.

[Figure 9] Figure 9 is a view for describing the outline of an example of another system of measurement for determining the X-ray diffraction profile from a plate sample by the $\phi$ scan method.

[Figure 10] Figure 10 is an example of the charts obtained by performing the $\phi$ scan measurement shown in Figure 9 on the Miller index planes <111>, <220>, <311>, and <400>.

[Figure 11] Figure 11 is a view for describing the outline of an example of another system of measurement for determining the X-ray diffraction profile from a plate sample by the $\phi$ scan method.

[Figure 12] Figure 12 shows an example of the $\phi$ scan chart on the Miller index planes <111> and <220> of a plate sample.

[Figure 13A] Figure 13A is a view showing a histogram of the absolute value of the amount of change (first derivative values) per a unit rotation angle of the diffraction intensity of the baseline of the $\phi$ scan chart of a plate sample collected from a polycrystalline silicon rod C (from which the FZ crystal line has disappeared) having a skewness calculated from the $\phi$ scan chart of the Miller index plane <111> of 1.15.

[Figure 13B] Figure 13B is a view showing a histogram of the absolute value of the amount of change (first derivative values) per a unit rotation angle of the diffraction intensity of the baseline of the $\phi$ scan chart of a plate sample collected from a polycrystalline silicon rod D (from which the FZ crystal line has not disappeared) having a skewness calculated from the $\phi$ scan chart of the Miller index plane <111> of 1.12.

Description of Embodiments

In the investigations on the improvement of quality of polycrystalline silicon for stably producing single crystal silicon, the present inventors have obtained the knowledge that a difference is produced in the degree of crystal grain size distribution in a polycrystalline silicon rod by the difference in various conditions during the deposition of polycrystalline silicon.

The "crystal grain size distribution" as described herein is evaluated by the skewness of the normal distribution obtained by determining the amount of change per a unit rotation angle of the diffraction intensity of the baseline of the $\phi$ scan chart obtained by X-ray diffraction measurement as the absolute value of first derivative values and preparing a histogram of these absolute values.

Specifically, a plate sample of polycrystalline silicon is prepared; the plate sample is disposed at a position where Bragg reflection from a Miller index plane <hkl> is detected; the plate sample is rotated in-plane about the center thereof by a rotation angle $\phi$ so that an X-ray irradiation region defined by a slit $\phi$-scans a principal plane of the plate sample; a $\phi$ scan chart showing the dependence of the intensity of the Bragg reflection from the Miller index plane <hkl> on the rotation angle $\phi$ of the plate sample is determined; the amount of change per a unit rotation angle of the diffraction intensity of the baseline of the $\phi$ scan chart is determined as a first derivative value; skewness in the normal distribution of the absolute value of the amount of change is calculated by the following equation; and the skewness (b value) is used as an evaluation index of the crystal grain size distribution (the degree of the distribution width).

[Expression 3]

$$b = \frac{\left| n\sum_{i=1}^{n}\left(\frac{x_i - \bar{x}}{s}\right)^3 \right|}{\left|(n-1)(n-2)\right|}$$

In the equation, n represents the number of data; s represents standard deviation; $x_i$ represents the i-th data; and x bar represents an average value.

The number of data n is determined by the angle for performing a scan and the unit rotation angle in the measurement. The angle for performing a scan is preferably 90° or more and 360° or less, and the unit rotation angle to be used is preferably 0.09° or more and 3° or less, more preferably 0.18° or more and 1.5° or less.

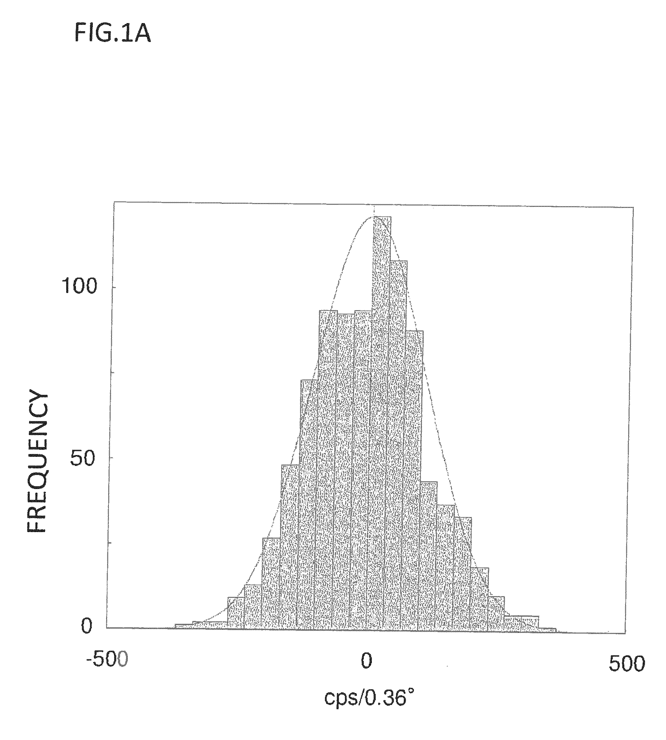

Figure 1A is a view showing an example in which the amount of change per a unit rotation angle of the diffraction intensity of the baseline of the $\phi$ scan chart as described above is determined as a first derivative value, and a histogram of the derivative values is prepared. The axis of abscissas represents the first derivative value (cps/0.36°), and the axis of ordinates represents frequency. Statistically, a $b_1$ value defined by the following equation is skewness; the $b_1$ value is an index showing the symmetry of distribution, in which when $b_1 = 0$, the distribution will be bilaterally symmetrical; when $b_1 > 0$, the distribution will be stretched on the right side; and when $b_1 < 0$, the distribution will be stretched on the left side.

[Expression 4]

$$b_1 = \frac{n\sum_{i=1}^{n}\left(\frac{x_i - \bar{x}}{s}\right)^3}{(n-1)(n-2)}$$

In the equation, n represents the number of data; s represents standard deviation; $x_i$ represents the i-th data; and x bar represents an average value.

However, in the present invention, the above first derivative value is not used as it is, but the skewness in the normal distribution of the absolute value of the amount of change is calculated.

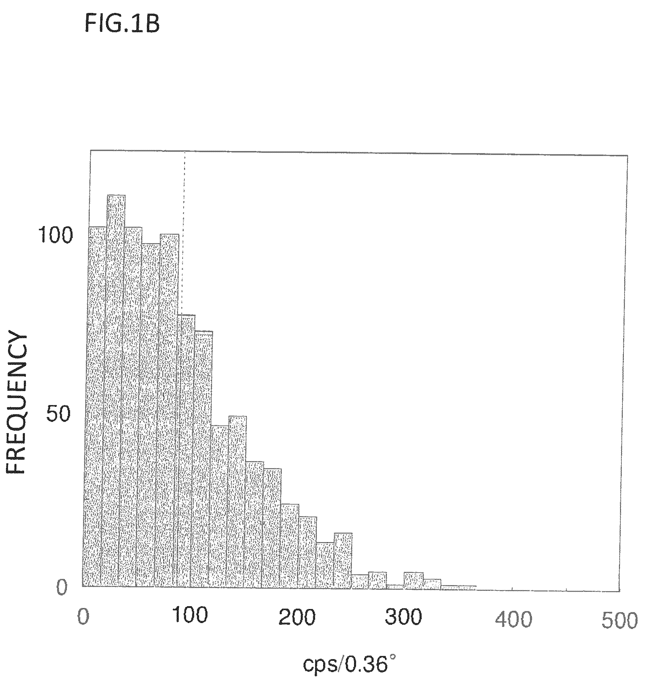

Figure 1B is a view showing a histogram of the absolute value of the data shown in Figure 1A.

According to the investigations of the present inventors, the larger the width of crystal grain size distribution is, the larger the above skewness (b value) will be, and the smaller the width of crystal grain size distribution is, the smaller the b value will be. With respect to this point, the present inventors understand as follows.

According to the $\phi$ scan method as described above, a scan chart is obtained by setting a plate crystal which is an evaluation target at an angle from which the diffraction from a specific Miller index <hkl> is obtained and rotating the crystal in this state. Therefore, when there is no distribution in the crystal grain size (that is, the crystal grain size is uniform), the diffraction intensity of the baseline of the $\phi$ scan chart is constant. However, if there is a region where the crystal grain size is locally different from that in other regions, the diffraction from this region will be different from that from other regions, and the diffraction intensity of the baseline will change. That is, it is expected that the amount of change of the diffraction intensity of the baseline of the $\phi$ scan chart reflects the distribution of the crystal grain size.

In the present invention, the amount of change per a unit rotation angle of the diffraction intensity of the baseline of the φ scan chart is determined as a first derivative value. Then, skewness (b value) in the normal distribution of the absolute value of the amount of change is calculated, and the skewness (b value) is used as an evaluation index of the crystal grain size distribution (the degree of the distribution width).

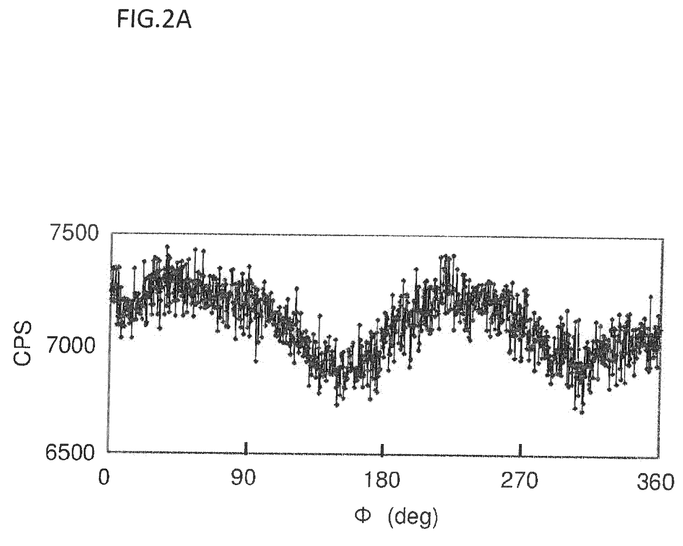

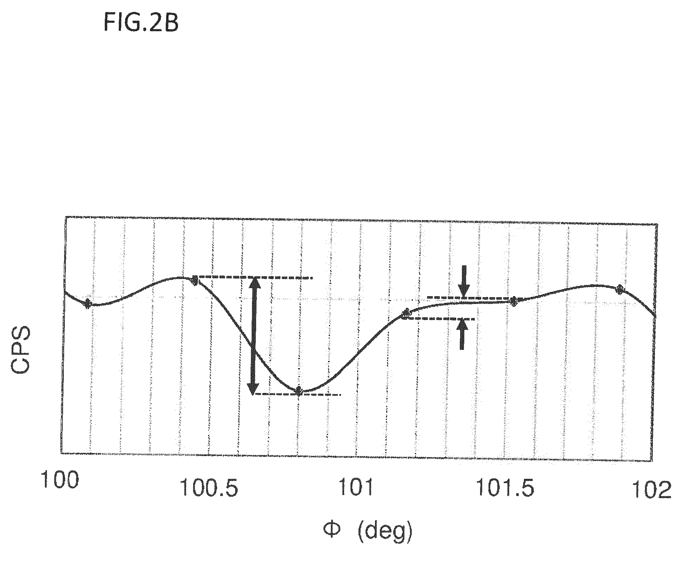

Figure 2A is an example of the φ scan chart (φ = 0 to 360°) obtained by scanning the Miller index plane <111>, and Figure 2B is a view in which the range of φ = 100 to 102° of this φ scan chart has been expanded. Note that this φ scan chart has been obtained by the measurement in which a sample is rotated by a unit of 0.36° (step feed).

In the regions shown in Figure 2B, the change of the diffraction intensity of the baseline between φ = 100.45° and 101.80° is relatively large, and the change of the diffraction intensity (ΔCPS) of the baseline between φ = 101.16° and 101.52° is relatively small. The large diffraction intensity change (ΔCPS) suggests that the crystal grain size distribution of this region is relatively large.

Note that the present inventors have verified that the ΔCPS shows good correlation with a value of the crystal grain size calculated by electron backscatter diffraction measurement (EBSD measurement).

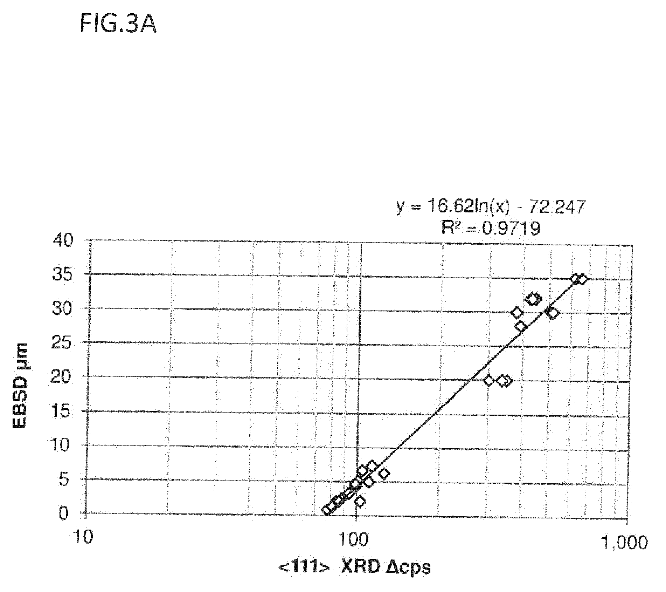

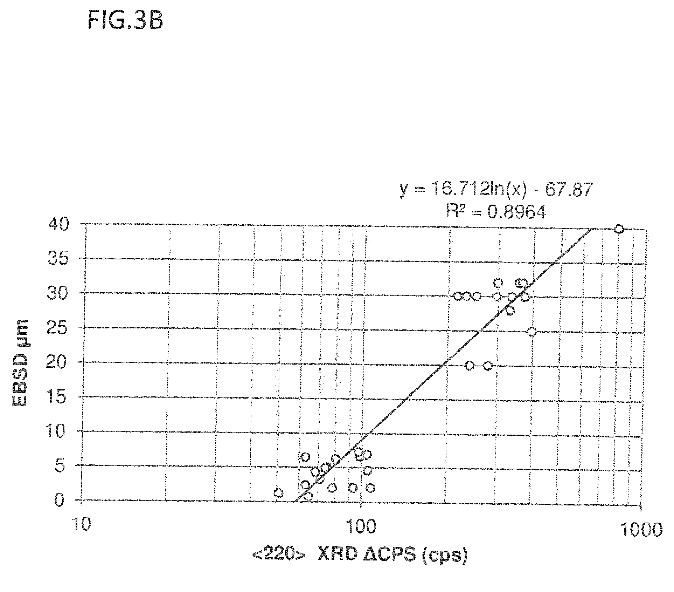

Figure 3A and Figure 3B are views showing the correlation and regression between the diffraction intensity change (ΔCPS) determined from the φ scan charts obtained by X-ray diffraction from the Miller index planes <111> and <220>, respectively, and the values of the crystal grain size calculated from the results of EBSD measurement.

With respect to the data of the Miller index plane <111> shown in Figure 3A, the correlation coefficient r by first regression equation is 0.99, and with respect to the data of the Miller index plane <220> shown in Figure 3B, a correlation coefficient r of 0.95 has been obtained. These results mean that the absolute value of the first derivative value can be utilized for the conversion of the crystal grain size.

That is, it is found that when the amount of change per a unit rotation angle of the diffraction intensity of the baseline of the φ scan chart is determined by the above technique as a first derivative value, and the skewness in the normal distribution of the absolute value of the amount of change is calculated, the degree of crystal grain size distribution can be evaluated by the skewness.

Hereinafter, the embodiments of the present invention will be described with reference to drawings.

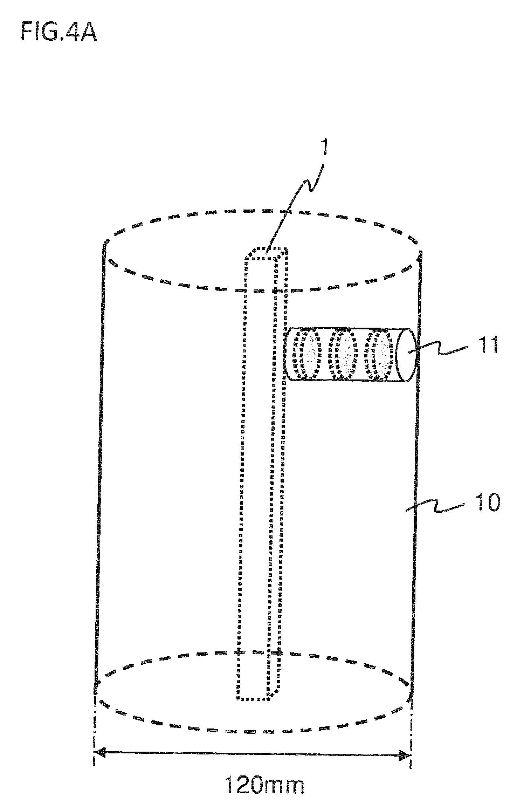

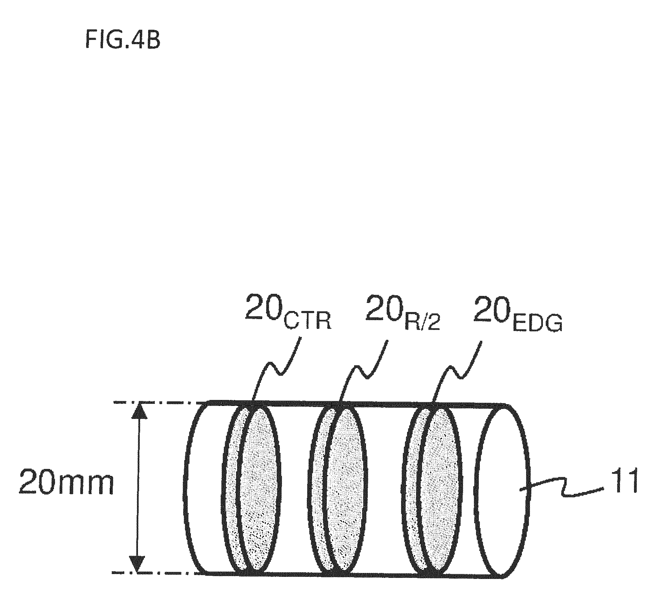

Figure 4A and Figure 4B are views for describing examples of collecting plate samples 20 for measuring X-ray diffraction profiles from a polycrystalline silicon rod 10 grown by deposition by a chemical vapor deposition method such as the Siemens method. In Figure 4A, reference numeral 1 denotes a silicon core wire for depositing polycrystalline silicon on the surface thereof to form a silicon rod.

Note that, in this example, the plate samples 20 are collected from three regions (CTR: a region close to the silicon core wire 1, EDG: a region close to the sidewall of the polycrystalline silicon rod 10, R/2: an intermediate region between CTR and EGD) in order to check the presence or absence of the diameter direction dependence of the crystal grain size of the polycrystalline silicon rod 10, but the collection of the plate samples is not limited to the sampling from such a region.

The diameter of the polycrystalline silicon rod 10 illustrated in Figure 4A is about 120 mm, and a rod 11 having a diameter of about 20 mm and a length of about 60 mm is hollowed out from the sidewall side of the polycrystalline silicon rod 10 perpendicularly to the longitudinal direction of the silicon core wire 1.

Then, as illustrated in Figure 4B, disk samples ($20_{CTR}$, $20_{EDG}$, and $20_{R/2}$), each having a section perpendicular to the direction of the diameter of the polycrystalline silicon rod 10 as a principal plane and having a thickness of about 2 mm, are collected from the region close to the silicon core wire 1 (CTR), the region close to the sidewall of the polycrystalline silicon rod 10 (EDG), and the intermediate region between CTR and EGD (R/2), respectively, of the rod 11.

Note that, although the region from which the rod 11 is collected and the length and the numbers of the rod 11 may be suitably determined depending on the diameter of the silicon rod 10 and the diameter of the rod 11 to be hollowed out, and the disk samples 20 may also be collected from any region of the hollowed-out rod 11, the rod and the disk samples are preferably collected from positions where the overall properties of the silicon rod 10 can be rationally estimated.

For example, when two disk samples are acquired, it is preferred to acquire the two samples from two positions, that is, a position located closer to the center from a point which is located at 1/2, from the center, of the radius of the circumference of a silicon rod and a position located outside the point.

From the point of view of increasing the comparison accuracy of the crystal grain size distribution, it is preferred to acquire the two samples from two positions, that is, a position located closer to the center from a point which is located at 1/3, from the center, of the radius of the circumference of a silicon rod and a position located outside a point which is located at 2/3, from the center, of the radius of the circumference of the silicon rod.

Note that, it is needless to say that when the number of disk samples to be collected is increased, the evaluation accuracy will be improved depending on the increase; therefore, three or more disk samples may be collected for evaluation.

Further, a diameter of the disk sample 20 of about 20 mm is for illustration only, and the diameter may be suitably determined in the range where the X-ray diffraction measurement can be performed without any trouble.

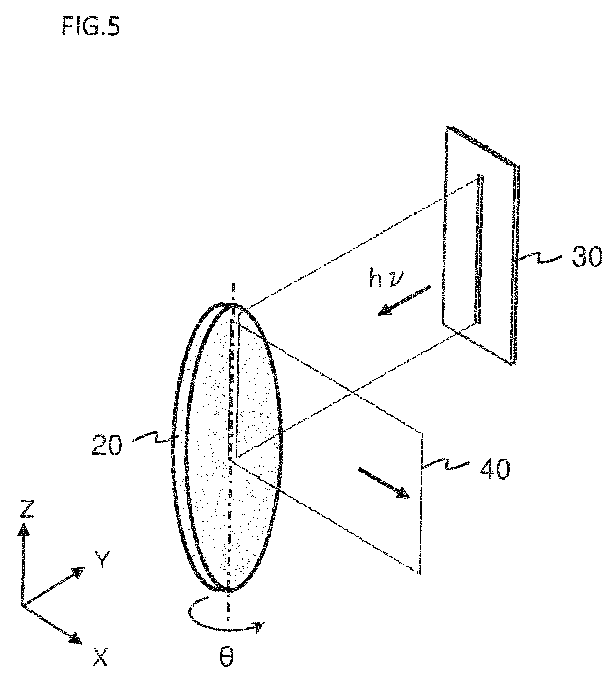

Figure 5 is a view for describing the outline of an example of a system of measurement for determining the X-ray diffraction profile from a disk sample 20 by a so-called $\theta$-$2\theta$ method. An X-ray beam 40 (Cu-K$\alpha$ rays: wavelength of 1.54 A) emitted from a slit 30 and collimated is incident into the disk sample 20. The intensity of the diffracted X-ray beam per each sample rotation angle ($\theta$) is detected with a detector (not illustrated) while rotating the disk sample 20 in an XY plane to obtain a $\theta$-$2\theta$ X-ray diffraction chart.

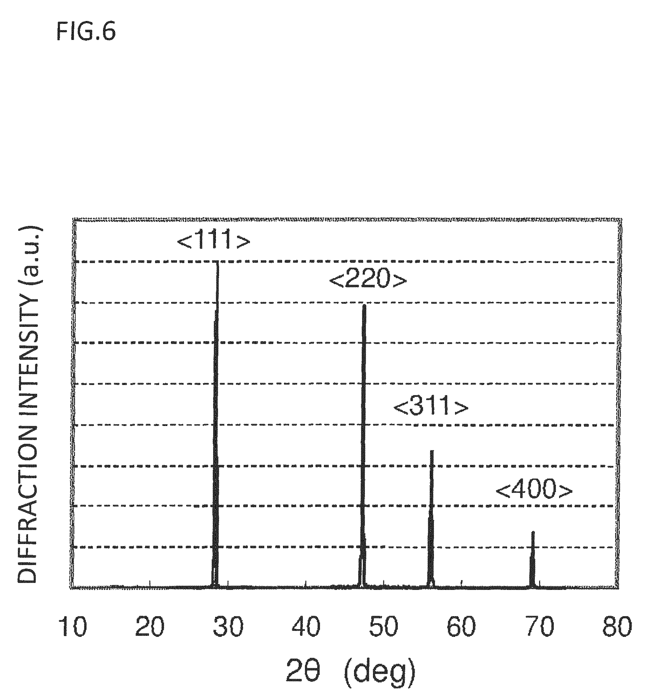

Figure 6 shows the example of the $\theta$-$2\theta$ X-ray diffraction chart obtained above, in which strong Bragg reflections from the Miller index planes <111>, <220>, <311>, and <400> appear as peaks at positions of $2\theta$ = 28.40°, 47.24°, 55.98°, and 68.98°, respectively.

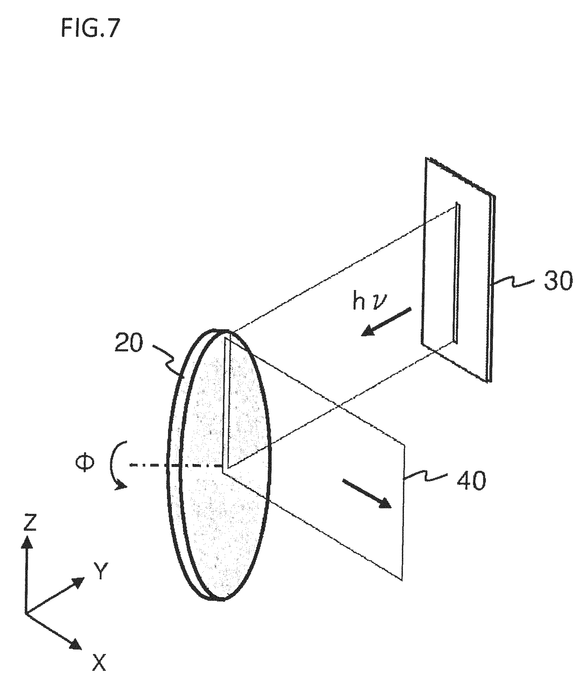

Figure 7 is a view for describing the outline of a system of measurement for determining the X-ray diffraction profile from a disk sample 20 by a so-called $\phi$ scan method. For example, the above $\theta$ of the disk sample 20 is set to an angle from which the Bragg reflection from the Miller index plane <111> is detected. In this state, the region from the center of the disk sample 20 to the peripheral edge thereof is irradiated with X-rays in a narrow rectangular region provided by a slit. The disk sample 20 is rotated about the center thereof in a YZ plane ($\phi$ = 0° to 360°) so that the X-ray irradiation region may scan the whole area of the disk sample 20.

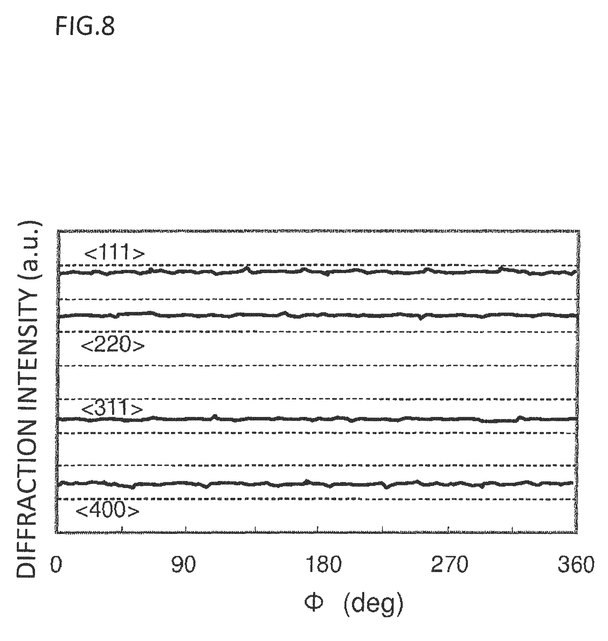

Figure 8 is an example of the charts obtained by performing the above $\phi$ scan measurement on the Miller index planes <111 >, <220>, <311 >, and <400>. In this example, the Bragg reflection intensity is generally constant even when any of the above Miller index planes is paid attention to, and the Bragg reflection intensity is hardly dependent on the rotation angle $\phi$. Thus, these charts are similar to the chart of a powder sample.

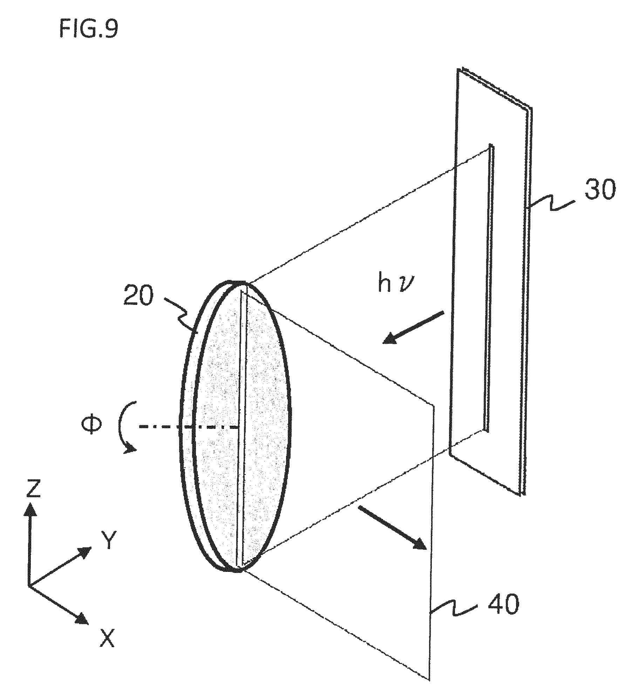

Figure 9 is a view for describing the outline of an example of another system of measurement for determining the X-ray diffraction profile from a disk sample 20 by the $\phi$ scan method. In the example shown in this view, the region over both the peripheral edges of the disk sample 20 is irradiated with X-rays in a narrow rectangular region provided by a slit. The disk sample 20 is rotated about the center thereof in a YZ plane ($\phi$ = 0° to 180°) so that the X-ray irradiation region may scan the whole area of the disk sample 20. Note that the measurement is performed by moving the rotation angle during data sampling by a unit of 0.36° (step feed).

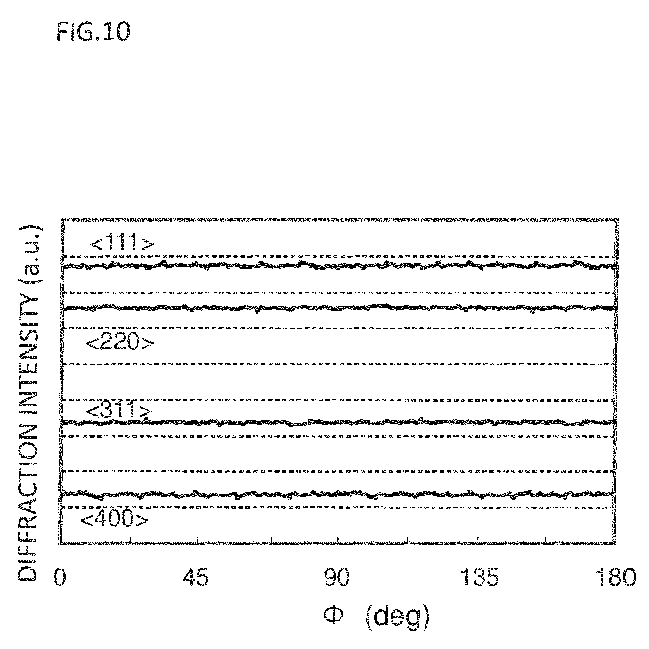

Figure 10 is an example of the chart obtained by performing the above $\phi$ scan measurement on the Miller index planes <111 >, <220>, <311 >, and <400>, and a $\phi$ scan chart substantially the same as that shown in Figure 8 has been obtained.

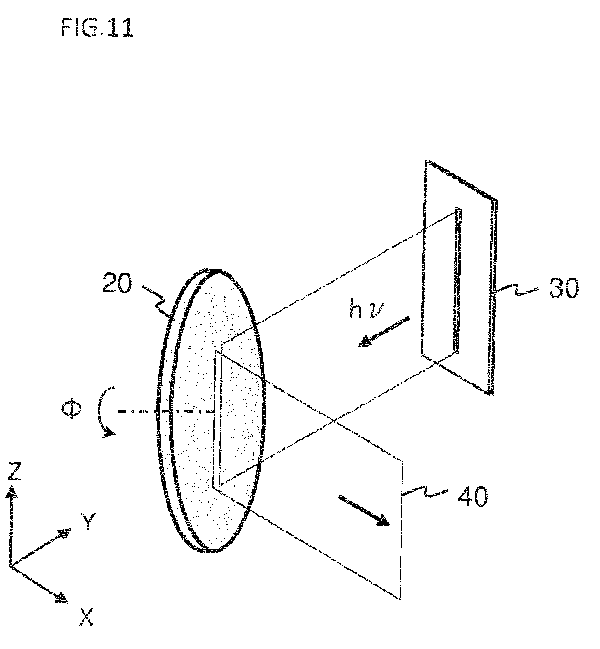

Figure 11 is a view for describing the outline of an example of another system of measurement for determining the X-ray diffraction profile from a disk sample 20 by the $\phi$ scan method. In the example shown in this view, only the inner peripheral region of the disk sample 20 instead of the whole principal plane thereof is irradiated with X-rays. The disk sample 20 is rotated about the center thereof in a YZ plane ($\phi$ = 0° to 180°) so that the X-ray irradiation region may scan the whole area of the disk sample 20.

When treatment is performed in which a difference between the $\phi$ scan chart obtained from such an X-ray irradiation region and the $\phi$ scan chart obtained from the whole principal plane of the disk sample 20 as described above is determined, it will be possible to obtain crystal grain size distribution in plane of the disk sample 20. Then, when such crystal grain size distribution is compared between different places, it will be possible to evaluate the difference (location dependence) of crystal grain size distribution in plane of the disk sample 20.

However, although in-plane crystal grain size distribution will probably not occur on the disk sample 20 collected in the embodiment as shown in Figures 4A and 4B, it is needless to say that the evaluation of the crystal grain size according to the present invention is significant not only as a method for selecting a polycrystalline silicon rod grown by the Siemens method or the like but also as a method for evaluating the crystal grain size of polycrystalline silicon by an X-ray diffraction method.

Therefore, for example, when a disk sample cut out in parallel with the diameter direction of a polycrystalline silicon rod grown by deposition by a chemical vapor deposition method is determined for the in-plane crystal grain size distribution, it will also be possible to know (the presence or absence of) the crystal grain size distribution in a polycrystalline silicon rod, the change of crystal grain size distribution accompanying the enlargement of the diameter of a polycrystalline silicon rod, or the like, thereby allowing selection of a polycrystalline silicon rod suitable as a raw material for producing single crystal silicon.

Patent Literature 2 as described above discloses that when the proportion of needle crystals which are present in a polycrystalline silicon rod is high, a crystal line will disappear when the single crystal is pulled up by the FZ method. Particularly, needle crystals which are present in the inner region of a polycrystalline silicon rod are easily in an unmelted state even after passing the "drawn" portion which is a floating zone (heat melting zone) during the FZ pulling up, thus disappearing the crystal line.

Certainly, if such needle crystals as described in Patent Literature 2 are present in a polycrystalline silicon rod, the needle crystals will be easily in an unmelted state locally, which, as a result, will cause to disappear the crystal line during pulling up of the single crystal by the FZ method.

However, according to the investigations of the present inventors, even when single crystal silicon is grown by the FZ method using, as a raw material, a polycrystalline silicon rod in which the presence of such needle crystals is not observed at all, there has been observed the apparent influence of production conditions (temperature, gas flow rate, TSC concentration, and the like) of the polycrystalline silicon rod on the presence or absence of the disappearance of the crystal line. That is, a polycrystalline silicon rod suitable as a raw material for producing single crystal silicon cannot sufficiently be evaluated from the point of view of the existence or nonexistence, the density, or the location of a macroscopic hardly-melted portion such as needle crystals.

Therefore, the present inventors have attempted to evaluate crystal grain size distribution of polycrystalline silicon by an X-ray diffraction method in order to select a polycrystalline silicon rod suitable as a raw material for producing single crystal silicon.

According to the investigations of the present inventors, when plate samples are collected from a large number of polycrystalline silicon rods and repeatedly evaluated by the methods as described above, it has been found that there is a correlation between the degree of crystal grain size distribution and the disappearance of the crystal line in the step of forming a single crystal.

That is, it has been found that, when polycrystalline silicon having a large degree of crystal grain size distribution is used as a raw material for forming a single crystal, a partially unmelted portion locally occurs, which may induce the formation of dislocation to cause the disappearance of the crystal line.

Thus, in the present invention, when the crystal grain size distribution of polycrystalline silicon is evaluated by an X-ray diffraction method, a plate sample of the polycrystalline silicon is prepared; the plate sample is disposed at a position where Bragg reflection from a Miller index plane <hkl> is detected; the plate sample is rotated in-plane about the center thereof by a rotation angle φ so that an X-ray irradiation region defined by a slit φ-scans the principal plane of the plate sample; a φ scan chart showing the dependence of the intensity of the Bragg reflection from the Miller index plane <hkl> on the rotation angle (φ) of the plate sample is determined; the amount of change per a unit rotation angle of the diffraction intensity of the baseline of the φ scan chart is determined as a first derivative value; skewness in the normal distribution of the absolute value of the amount of change is calculated by the equation described above; and the skewness (b value) is used as an evaluation index of the crystal grain size distribution.

Here, the Miller index plane <hkl> is preferably any of a plane <111 > and a plane <220>.

Further, in the present invention, when a polycrystalline silicon rod grown by deposition by a chemical vapor deposition method to be used as a raw material for producing single crystal silicon is selected using an X-ray diffraction method, the skewness (b value) as an evaluation index of the crystal grain size distribution is used to determine the suitability as a raw material for producing single crystal silicon.

For example, when the Miller index <hkl> is a plane <111> and the b value is 1.12 or less, the polycrystalline silicon rod is selected as a raw material for producing single crystal silicon.

Further, for example, when the Miller index <hkl> is a plane <220> and the b value is 1.12 or less, the polycrystalline silicon rod is selected as a raw material for producing single crystal silicon.

Here, the polycrystalline silicon rod is grown, for example, by the Siemens method.

The polycrystalline silicon rod selected by the method of the present invention has relatively high uniformity of crystal grain size in the meaning that a local unmelted state hardly occurs. Therefore, occurrence of the local unmelted state is suppressed and the stable production of single crystal silicon is achieved when a single crystal is grown by the FZ method using such a polycrystalline silicon rod or when a single crystal is grown by the CZ method using a polycrystalline silicon block obtained by crushing the polycrystalline silicon rod.

Note that, when the φ scan chart on the Miller index plane <hkl> of a plate sample has almost constant diffraction intensity as shown in Figures 6 and 8, this φ scan chart itself can be treated as a "baseline", but "waviness" may be observed in the φ scan chart, depending on a case.

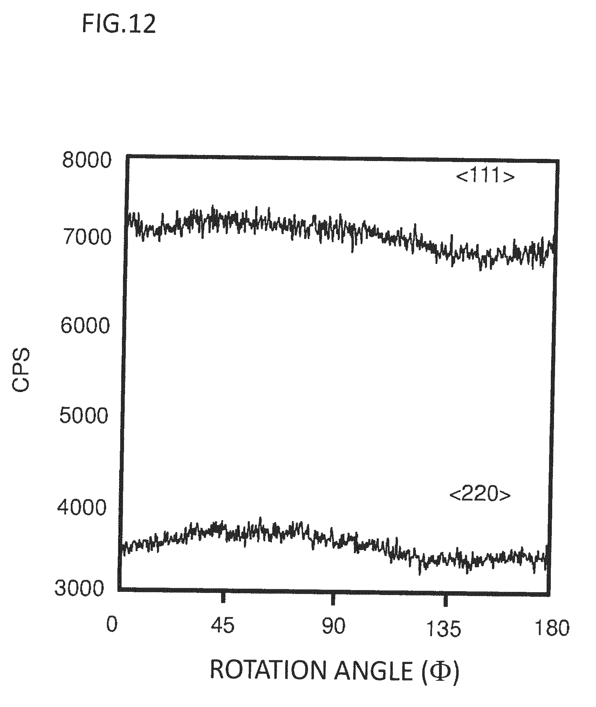

Figure 12 shows an example of the φ scan chart in which the "waviness" is observed on the Miller index planes <111> and <220> of a plate sample. Note that these samples are collected from the same polycrystalline silicon rod, and these φ scan charts are obtained by the measurement of the embodiment shown in Figure 7.

Although "waviness" is observed on the baseline of the φ scan chart on the Miller index plane <111 >, the method of determining the amount of change per a unit rotation angle of the diffraction intensity as a first derivative value and calculating skewness in the normal distribution of the absolute value of the amount of change can be performed without any trouble.

Similarly, although "waviness" is observed on the baseline of the φ scan chart on the Miller index plane <220>, skewness is calculated in the same manner as in <111 >.

Note that a φ scan chart not always has almost constant diffraction intensity as shown in Figures 6 and 8, but a peak-like diffraction intensity distribution may appear in a φ scan chart, depending on a case.

For example, when the plate sample used for the measurement contains needle crystals, these needle crystals show a strong peak under the diffraction conditions of the Miller index plane <220>. Therefore, in order to determine the baseline of the φ scan chart, this peak needs to be removed from the φ scan chart.

For this purpose, for example, the following method is effective: when peak-like diffraction intensity distribution has appeared in a φ scan chart, the intensity having an S/N ratio of 3 or more is determined to be a "peak"; and the baseline is determined according to a technique of determining the baseline when the peak intensity of the peak part is integrated.

Examples

Seven polycrystalline silicon rods grown under different deposition conditions were prepared. Each of these polycrystalline silicon rods (silicon rods A to G) was used to collect a plurality of plate samples each having a thickness of 2 mm at an interval of 10 mm or 20 mm in the diameter direction, and the samples were used to obtain $\phi$ scan charts of the Miller index planes <111> and <220> using the system of measurement shown in Figure 7. Note that the diameter of the disk sample 20 is about 20 mm.

Note that since the rotation angle during data sampling is moved by a unit of 0.36° (step feed) for rotating 360°, the number of data (n) per a sample is 999.

Further, single crystal silicon rods were grown by the FZ method using the above seven polycrystalline silicon rods (A to G).

Table 1 summarizes the skewness of the Miller indices <111> and <220> obtained from the $\phi$ scan charts described above, the number of samples (N) collected from the polycrystalline silicon rods, the presence or absence of needle crystals, and the disappearance or not of the crystal line when single crystal silicon rods are grown by the FZ method using these polycrystalline silicon rods. Note that the presence or absence of needle crystals was checked by the technique described in Patent Literature 2.

[Table 1]

| Silicon rod | Skewness <111> | Skewness <220> | Number of sample N | Number of data n | Total number of data N·n | Presence or absence of needle crystals | Disappearance of FZ crystalline |
|---|---|---|---|---|---|---|---|
| A | 1.68 | 1.22 | 7 | 999 | 6,993 | Absent | Yes |
| B | 1.26 | 1.26 | 10 | 999 | 9,990 | Present | Yes |
| C | 1.15 | 1.65 | 12 | 999 | 11,98 8 | Absent | Yes |
| D | 1.12 | 1.12 | 10 | 999 | 9,988 | Present | No |
| E | 1.12 | 1.12 | 10 | 999 | 9,990 | Present | No |
| F | 0.99 | 1.08 | 5 | 999 | 4,995 | Absent | No |
| G | 1.00 | 1.08 | 10 | 999 | 9,988 | Absent | No |

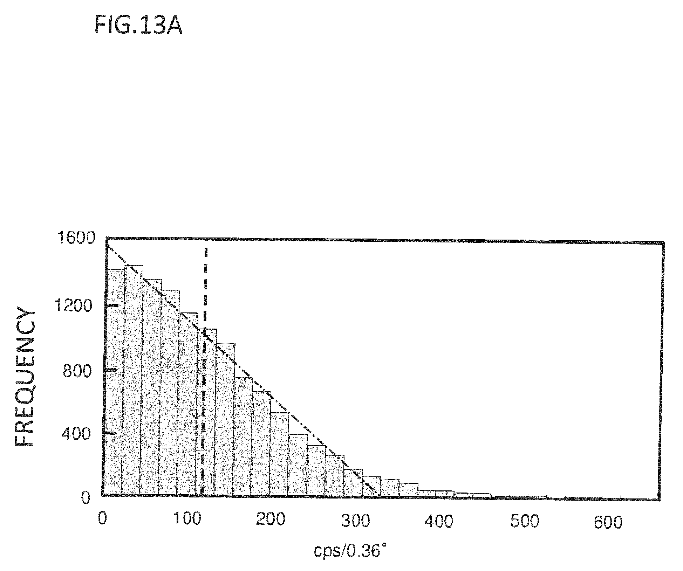

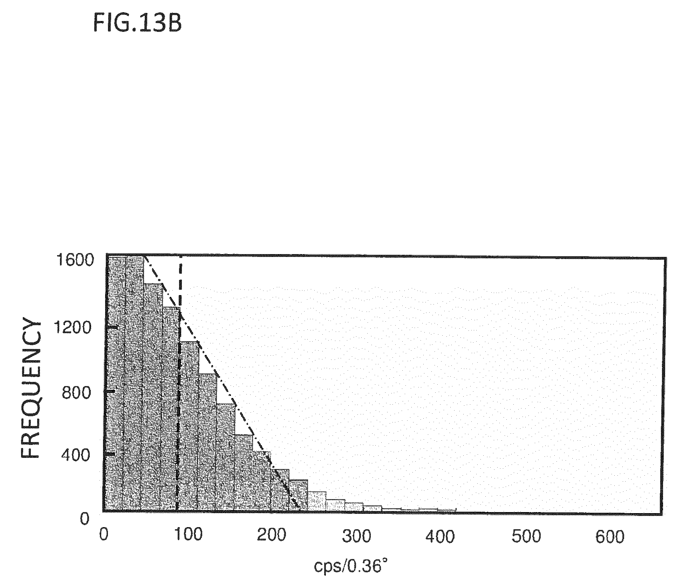

Figure 13A and Figure 13B are views showing histograms of the absolute value of the amount of change (first derivative values) per a unit rotation angle of the diffraction intensity of the baseline of the $\phi$ scan chart of plate samples collected from a polycrystalline silicon rod C having a skewness calculated from the $\phi$ scan chart of the Miller index plane <111> of 1.15 and a polycrystalline silicon rod D having a skewness calculated from the $\phi$ scan chart of the Miller index plane <111> of 1.12, respectively. The axis of abscissas represents the first derivative value (cps/0.36°), and the axis of ordinates represents frequency.

The disappearance of the FZ crystal line was observed in the silicon rods A, B, and C, while the disappearance of the FZ crystal line was not observed in the silicon rods D, E, F, and G.

When the skewness (b value) of the Miller index planes <111> and <220> of these silicon rods are checked, all the silicon rods in which the disappearance of the FZ crystal line was not observed has a b value of 1.12 or less when the Miller index <hkl> is the plane <111 >.

Further, all the silicon rods in which the disappearance of the FZ crystal line was not observed has a b value of 1.12 or less also when the Miller index <hkl> is the plane <220>.

On the other hand, all the silicon rods in which the disappearance of the FZ crystal line was observed has a b value of more than 1.12 when the Miller index <hkl> is the plane <111>, and has a b value of more than 1.12 also when the Miller index <hkl> is the plane <220>.

Further, in the silicon rods having a b value of 1.12 or less like silicon rods D and E, the disappearance of the crystal line has not occurred in the step of forming the FZ single crystal even if these silicon rods contain needle crystals. On the other hand, in the silicon rods having a b value of more than 1.12 like silicon rods A and C, the disappearance of the crystal line has occurred in the step of forming the FZ single crystal even if the presence of needle crystals is not observed in these silicon rods.

These results mean that even if single crystal silicon is produced by using, as a raw material, a polycrystalline silicon rod in which macroscopic needle crystals observed by visual observation are not identified, such as that disclosed in Patent Literature 2, the disappearance of the crystal line resulting from the induction of the occurrence of dislocation may occur; and, conversely, even if macroscopic needle crystals are identified in a polycrystalline silicon rod, such a polycrystalline silicon rod will be suitable as a raw material for producing single crystal silicon.

The present inventors understand the reason of the above results as follows. A polycrystalline silicon rod having a b value of 1.12 or less has relatively high uniformity of crystal grain size in the meaning that a local unmelted state hardly occurs. Therefore, occurrence of a local unmelted state is suppressed when a single crystal is grown by the FZ method using such a polycrystalline silicon rod or when a single crystal is grown by the CZ method using a polycrystalline silicon block obtained by crushing the polycrystalline silicon rod.

That is, in order to uniformly heat and melt silicon polycrystal in the step of forming a single crystal, it is required that the degree of the grain size distribution of polycrystalline silicon be small, particularly that a region having a large grain size which easily causes occurrence of an unmelted region be not contained. Thus, it is believed that since a polycrystalline silicon having a b value of 1.12 or less does not contain such a region and does not inhibit thermal conduction and thermal diffusion, single crystal silicon can be stably produced.

Industrial Applicability

The present invention provides a technique of selecting polycrystalline silicon suitable as a raw material for producing single crystal silicon with high quantitativity and reproducibility and contributing to the stable production of single crystal silicon.

Reference Signs List

1      Silicon core wire
10     Polycrystalline silicon rod
11     Rod
20     Plate sample
30     Slit
40     X-ray beam

**Claims**

1.   A method for evaluating crystal grain size distribution of polycrystalline silicon by an X-ray diffraction method, the method comprising:

preparing a plate sample of the polycrystalline silicon;
disposing the plate sample at a position where Bragg reflection from a Miller index plane <hkl> is detected;
rotating the plate sample in-plane about the center thereof by a rotation angle $\phi$ so that an X-ray irradiation region defined by a slit $\phi$-scans a principal plane of the plate sample;
determining a $\phi$ scan chart showing the dependence of intensity of the Bragg reflection from the Miller index plane <hkl> on the rotation angle ($\phi$) of the plate sample;
determining the amount of change per a unit rotation angle of diffraction intensity of a baseline of the $\phi$ scan chart as a first derivative value;
calculating skewness in the normal distribution of the absolute value of the amount of change by the following equation:

[Expression 1]

$$b = \frac{\left| n\sum_{i=1}^{n}\left(\frac{x_i - \bar{x}}{s}\right)^3 \right|}{\left| (n-1)(n-2) \right|}$$

wherein n represents the number of data; s represents standard deviation; $x_i$ represents the i-th data; and x bar represents an average value; and
using the skewness (b value) as an evaluation index of the crystal grain size distribution.

2. The method for evaluating crystal grain size distribution of polycrystalline silicon according to claim 1, wherein the Miller index plane <hkl> is any of a plane <111> and a plane <220>.

3. A method for selecting a polycrystalline silicon rod to be used as a raw material for producing single crystal silicon using an X-ray diffraction method, the polycrystalline silicon rod being grown by deposition by a chemical vapor deposition method, the method for selecting the polycrystalline silicon rod comprising:

collecting a plate sample having a section perpendicular to a diameter direction of the polycrystalline silicon rod as a principal plane;
disposing the plate sample at a position where Bragg reflection from a Miller index plane <hkl> is detected;
rotating the plate sample in-plane about the center thereof by a rotation angle ϕ so that an X-ray irradiation region defined by a slit ϕ-scans the principal plane of the plate sample;
determining a ϕ scan chart showing the dependence of intensity of the Bragg reflection from the Miller index plane <hkl> on the rotation angle (ϕ) of the plate sample;
determining the amount of change per a unit rotation angle of diffraction intensity of a baseline of the ϕ scan chart as a first derivative value;
calculating skewness in the normal distribution of the absolute value of the amount of change by the following equation:

[Expression 2]

$$b = \frac{\left| n\sum_{i=1}^{n}\left(\frac{x_i - \bar{x}}{s}\right)^3 \right|}{\left| (n-1)(n-2) \right|}$$

wherein n represents the number of data; s represents standard deviation; $x_i$ represents the i-th data; and x bar represents an average value; and
using the skewness (b value) as an evaluation index of the crystal grain size distribution to determine the suitability as a raw material for producing single crystal silicon.

4. The method for selecting a polycrystalline silicon rod according to claim 3, wherein the Miller index plane <hkl> is any of a plane <111> and a plane <220>.

5. The method for selecting a polycrystalline silicon rod according to claim 4, wherein when the Miller index <hkl> is a plane <111>, and the b value is 1.12 or less, the polycrystalline silicon rod is selected as a raw material for producing single crystal silicon.

6. The method for selecting a polycrystalline silicon rod according to claim 4, wherein when the Miller index <hkl> is a plane <220>, and the b value is 1.12 or less, the polycrystalline silicon rod is selected as a raw material for producing single crystal silicon.

7. The method for selecting a polycrystalline silicon rod according to any one of claims 3 to 6, wherein the polycrystalline silicon rod is grown by the Siemens method.

8. A polycrystalline silicon rod selected by the method according to any one of claims 3 to 6.

9. A polycrystalline silicon block obtained by crushing the polycrystalline silicon rod according to claim 8.

10. A method for producing single crystal silicon using the polycrystalline silicon rod according to claim 8 as a silicon raw material.

11. A method for producing single crystal silicon using the polycrystalline silicon block according to claim 9 as a raw material.

FIG.1A

FIG.1B

cps/0.36°

FIG.2A

FIG.2B

## FIG.3A

$$y = 16.62\ln(x) - 72.247$$
$$R^2 = 0.9719$$

FIG.3B

$$y = 16.712\ln(x) - 67.87$$
$$R^2 = 0.8964$$

FIG.4A

120mm

FIG.4B

FIG.5

FIG.6

FIG.7

FIG.8

FIG.9

FIG.10

FIG.11

FIG.12

FIG.13A

FIG.13B

**INTERNATIONAL SEARCH REPORT**

| International application No. |
| --- |
| PCT/JP2014/002925 |

A.  CLASSIFICATION OF SUBJECT MATTER
*G01N23/207*(2006.01)i, *C01B33/02*(2006.01)i, *C30B29/06*(2006.01)i

According to International Patent Classification (IPC) or to both national classification and IPC

B.  FIELDS SEARCHED

Minimum documentation searched (classification system followed by classification symbols)
G01N23/207, C01B33/02, C30B29/06

Documentation searched other than minimum documentation to the extent that such documents are included in the fields searched
Jitsuyo Shinan Koho          1922-1996    Jitsuyo Shinan Toroku Koho    1996-2014
Kokai Jitsuyo Shinan Koho    1971-2014    Toroku Jitsuyo Shinan Koho    1994-2014

Electronic data base consulted during the international search (name of data base and, where practicable, search terms used)
JSTPlus(JDreamIII), CiNii

C.  DOCUMENTS CONSIDERED TO BE RELEVANT

| Category* | Citation of document, with indication, where appropriate, of the relevant passages | Relevant to claim No. |
| --- | --- | --- |
| A<br>X | WO 2012/164803 A1  (Shin-Etsu Chemical Co.,<br>Ltd.),<br>06 December 2012 (06.12.2012),<br>paragraphs [0015] to [0040]; fig. 1A to 6B<br>& US 2014/0033966 A1   & EP 2692909 A1<br>& CN 103547713 A        & KR 10-2014-0034260 A | 1-7<br>8-11 |
| A | JP 9-320032 A  (Fuji Electric Co., Ltd.),<br>12 December 1997 (12.12.1997),<br>paragraphs [0011] to [0014]<br>(Family: none) | 1-11 |
| A | Takeshi HOSHIKAWA et al., "Si multicrystals<br>grown by the Czochralski method with multi-<br>seeds", Journal of Crystal Growth, 2007.09.15,<br>Vol. 307, No. 2, p. 466-471 | 1-11 |

| ☐  Further documents are listed in the continuation of Box C. | ☐  See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>08 August, 2014 (08.08.14) | Date of mailing of the international search report<br>19 August, 2014 (19.08.14) |
| --- | --- |
| Name and mailing address of the ISA/<br>Japanese Patent Office | Authorized officer |
| Facsimile No. | Telephone No. |

Form PCT/ISA/210 (second sheet) (July 2009)

**EP 3 015 853 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3718861 B

- JP 2008285403 A